# EUROPEAN PATENT APPLICATION

(11) **EP 0 886 298 A2**
(43) Date of publication of application: **23.12.1998**
(21) Application number: 98304846.3
(22) Date of filing: 19.06.1998
(51) Int. Cl.: H01J 37/20, H01L 21/68

(54) **Method and apparatus of removing a sample adsorbed by static electricity from the sample stage**

(30) Priority: 20.06.1997 JP 163720/97
(71) Applicant: HITACHI, LTD., Chiyoda-ku, Tokyo (JP)
(72) Inventor: Ishimura, Hiroaki, Yamaguchi-Ken 744-0002 (JP); Tsubaki, Takeshi, Yamaguchi-Ken 745-0802 (JP); Satou, Takashi, Yamaguchi-Ken 744-0011 (JP); Nakata, Kenji, Yamaguchi-Ken 743-0012 (JP); Hirano, Hiroyoshi, Yamaguchi-Ken 744-0006 (JP); Yoshigai, Motohiko, Yamaguchi-Ken 743-0012 (JP); Sakaguchi, Masamichi, Yamaguchi-Ken 744-0012 (JP)
(74) Representative: Calderbank, Thomas Roger

(57) **Abstract**

The present invention relates to a method and apparatus for removing a sample which is held on a sample stage (8) in a vacuum chamber by means of an electrostatic adsorption voltage applied to the sample stage (8). The method includes a first step that pushes up a lift pin (18) to remove the sample from the sample stage (8) to a predetermined height and a second step that makes the lift pin (18) stand still for a predetermined time after an end of the first step. By repeating the first step and the second step, the sample is removed from the sample stage.

## Description

The present invention relates to a method and a apparatus of a sample adsorbed by static electricity from the sample stage in the vacuum processing chamber of semiconductor processors such as a plasma etching apparatus, the CVD (Chamical Vapor Deposition) apparatus, a sputtering apparatus or a ion implantation apparatus. More particularly, the present invention relates to a method and a apparatus of removing the sample that can be certainly removed from the sample stage without shifting the sample to a level direction.

As a conventional method of removing the sample adsorbed by static electricity from the sample stage, the one disclosed in, for example, Japan Patent Laid-Open No.252253/1994 is known. In this technique, the sample is pushed up by using the elastic power of a spring, and this sample is removed from the sample stage.

In the semiconductor surface treatment process using plasma, nothing is arranged other than a processed sample on the sample stage, and the sample is held, the etching apparatus using for example, plasma can use electrostatic adsorption hold like the above prior art. The time that is needed for the extinction of adsorption power in this apparatus needed a certain time to certainly make adsorption power extinct to change by the kind of the sample, a processing condition, etc., and there was a problem of reducing a throughput. Moreover, for an exchange with the wafer that is processed next in the state that adsorption power is high, by pushing up a wafer suddenly, a pin is pushed up, and the wafer is removed from the sample stage. The deviation of the wafer and the breakage of the wafer occurred on the case, and it had possibility of not being able to do a normal wafer transfer.

A first aspect of the invention proposes a sample removal method in which the sample that electrostatic-adsorbed that applied a electrostatic adsorption voltage to the sample state arranged in the vacuum chamber is removed from the sample stage, said method comprises the steps of:
a first step for pushing up a lift pin to remove the sample from the sample stage from the sample stage relatively to a predetermined height;
a second step for making the lift pin stand still for a predetermined time after an end of the first step;
by repeating the first step and the second step, the sample is removed from the sample stage.

A second aspect of the invention proposes a sample removal apparatus in which the sample that electrostatic-adsorbed that applied a electrostatic adsorption voltage to the sample stage arranged in the vacuum chamber is removed by a lift pin from the sample stage which comprises:
a drive unit for driving the lift pin relatively apart from the sample stage;
a control unit for controlling the drive unit to repeat the control that push up lift pin to remove the sample from the sample stage from the sample stage relatively to a predetermined height and the control that make the lift pin stand still for a predetermined time, and to remove the sample from the sample stage.

The present invention permits a sample removal method and apparatus to be provided that makes it possible to transfer the sample after processing promptly and certainly.

The present invention also permits a sample removal method and apparatus to be provided that makes removal possible without shifting the sample mounted on the sample stage to a level direction.

The present invention also permits a sample removal method and apparatus to be provided that permits removal without damaging the sample mounted on the sample stage.

By as mentioned above composing, the sample electrostatic-adsbrbed to the sample stage weakening the electrostatic adsorption power that works to the sample by the reaction force of the sample gradually is removed from the sample stage. Therefore, the sample can be removed from the sample stage without shifting to a level direction. And, the present has an effect that the sample after a processing end can be transferred promptly and certainly.

Fig. 1 shows the details of a unit of the plasma generation part of a plasma processor and a sample atage.

Fig. 2 illustrates the mechanism of a sample removal according to the present invention.

Fig. 3 illustrates an example of the flowchart of etching processing.

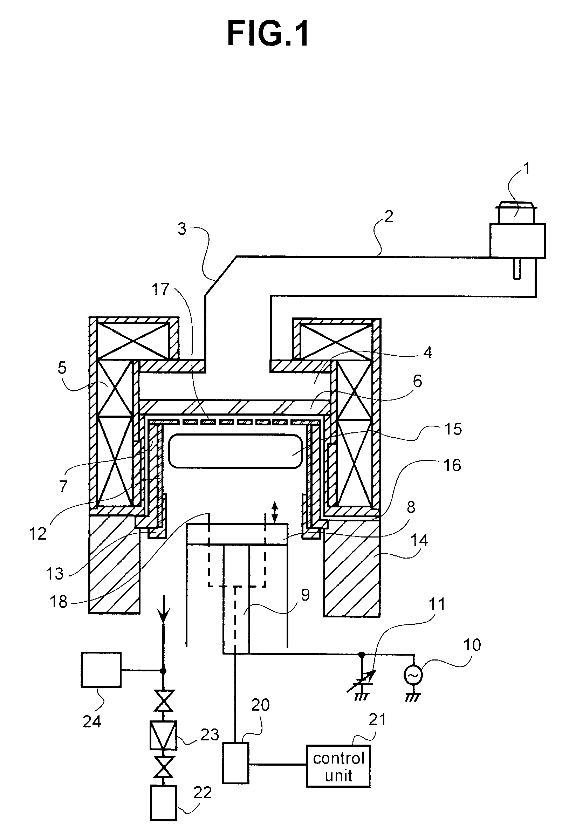

An embodiment of the present invention will now be described with reference to Fig. 1 - Fig. 3.

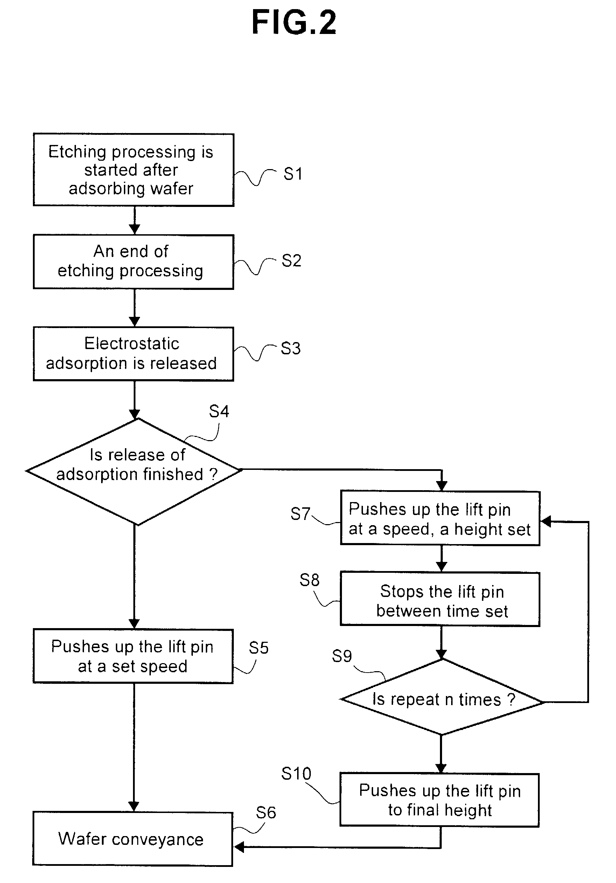

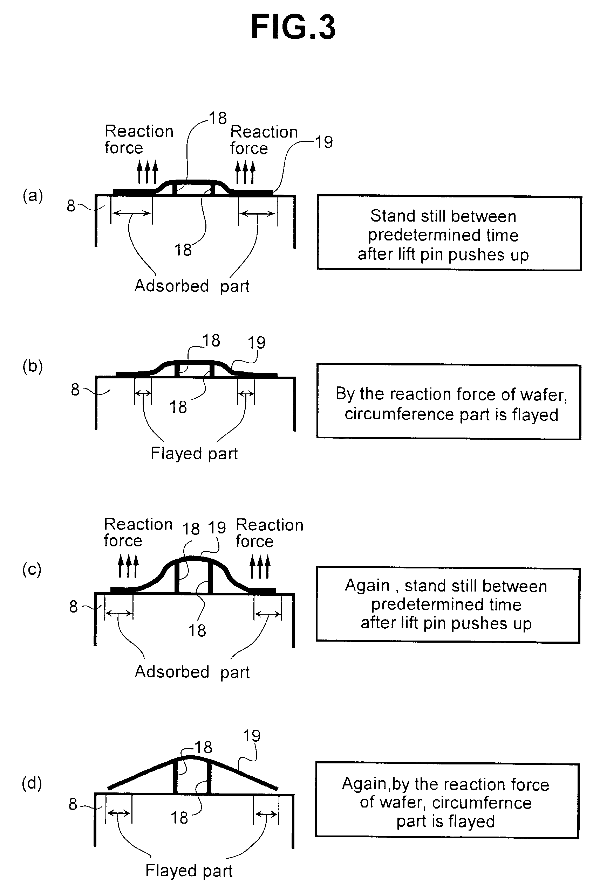

Fig. 1 shows the details of a unit of the plasma generation part of a plasma processor and a sample stage. Fig. 2 illustrates the mechanism of a sample removal according to the present invention. Fig. 3 illustrates an example of the flowchart of etching processing.

This embodiment uses a microwave and a magnetic field as a means of generating plasma. This apparatus has the following element. A magnetron 1 that generates a microwave, a rectangular waveguide 2 to transmit a microwave, a circular rectangular conversion waveguide 3, a cylindrical cavity part 4, solenoid coils 5 that generates a magnetic field, a microwave transmission window 6 (for example, flat board made of quartz), a vacuum chamber 7, a sample stage 8 on which a wafer that is a sample is arranged. a drive unit 9 that moves the sample stage 8 up and down. A high-frequency power 10 to apply a high-frequency bias voltage to the sample stage 8 in the term that the sample is processed by plasma such as etching. A power 11 for an electrostatic adsorption to statically adsorb the wafer that is arranged on the sample stage 8. a insulating cover 12 of a cylinder-form manufactured in the plasma-resistant material such as quartz, ceramics is arranged in the inside of the vacuum chamber 7. A ground electrode 13 that is the component of a earthing electric potential is arranged in the neighborhood of the sample stage 8 that is an electrode to the inside of the vacuum chamber 7. The ground electrode 13 is electrically connected to buffer room 14 that is a ground electric potential, and is arranged in the inside of the vacuum chamber 7. By composing like this, while the vacuum chamber 7 and the plasma 15 are electrically insulated with the insulating cover 12, the vacuum chamber 7 and the plasma 15 are electrically conducted. A lift pin 18 pushes up the sample on the sample stage 8, and removes the sample from the sample stage 8. A drive unit 20 that moves the lift pin 18 up and down. For example, drive unit 20 constitutes with stepping motor. It arranges several pins 18 with sample stage 8. In this case, sample stage 8 has four pins 18. As up and down drives the lift pin 18, the control unit 21 controls drive unit 20.

Process gas is introduced into the inside of the vacuum chamber 7 decompressed by a vacuum pump 22 and a turbo molecular pump 23 from the gas blow-off opening 17a of shower plate 17 through a gas introduction route 16 in the term of etching processing. The internal pressure of the vacuum chamber 7 is adjusted by a variable valve 24. And then, the magnetron 1 generates the microwave of 2.45GHZ.

The microwave generated from magnetron 1 injects into the inside of the vacuum chamber 7 through the waveguide 2, the circular rectangular conversion waveguide 3 and the microwave transmission window 6. Three solenoid coils 5 wound outside of the cylindrical cavity part 4 and the vacuum chamber 7 generate a magnetic field to the inside of the vacuum chamber 7. By an effect of this microwave and a magnetic field, The electron of process gas into which the vacuum chamber 7 is introduced inside is given energy efficiently. As a result, to the inside of the vacuum chamber 7, high dense plasma 15 by electronic cyclotron resonance is generated. A direct current voltage to make a wafer adsorb to the sample stage 8 is output from electrostatic adsorption power 11 after plasma generation.

In the electric circuit that is composed of the ground electrode 13, the electrostatic adsorption power 11 and the sample stage 8 through the plasma 15, the wafer itself between the sample stage 8 and the wafer has a capacity component. Therefore, the direct current voltage output from the electrostatic adsorption power 11 is charged between the sample stage 8 and the wafer, and as a result the wafer is adsorbed to the sample stage 8.

After adsorbing the wafer to the sample stage 8, a high-frequency bias voltage is output from the high-frequency power 10, and processing is started.

After an end of process processing, a electrostatic adsorption of the wafer is released. This release processing applies a backward voltage to the sample stage 18. The lift pin 18 is made to rise after confirmation of a release of the electrostatic adsorption of the wafer, the wafer is pushed up, and the wafer is removed from the sample stage 8.

However, when etching processing is done many times, an etching reaction product accumulates to the sample stage 8. By this accumulation thing, parameters such as a voltage that is optimum to the process of releasing the electrostatic adsorption fluctuate. Therefore, a state that even if electrostatic adsorption release processing is executed, a release of a electrostatic adsorption is not sufficient occurs. And, by excessive electrostatic adsorption processing, the wafer is adsorbed again, and a state like above occurs. When removing the wafer that did electrostatic adsorption release processing, a removal method like Fig. 2(A) - (D) is used in this case.

As follows, Fig. 2 is explained. First, the lift pin 18 is pushed up to the height set in the parameter. Then, between time set in the parameter, the lift pin 18 stands still. While lift pin 18 stands still, the circumference part of the wafer 19 comes off from sample stage 8 by the reaction force of the wafer 19. The lift pin 18 is made to rise further continuously, and when the lift pin 18 is made to stand still likewise with above, the circumference part of the wafer 19 comes off from the sample stage 8 by the reaction force of the wafer 19. The above step is iterated. By a raise of the wafer 19 only by a minute height by the lift pin 18 and use of the reaction force of the wafer 19 by it, this method can be certainly removed from the sample stage 8 without shifting the wafer 19 to a level direction. The flowchart of these etching processing is shown in Fig. 3.

In Fig. 2, the height where the lift pin 18 rises in 1 step is not a height that is sufficient to certainly remove the wafer 19 electrostatic-adsorbed to the sample stage 8 from the sample stage 8. This height is the height that divided a height that is sufficient to certainly remove the wafer 19 electrostatic-adsorbed to the sample stage 8 from the sample stage 8 into some. And then, the height that pushes up the lift pin 18 finally by several steps attains the height that can certainly remove the wafer 19 electrostatic-adsorbed to the sample atage 8. And, each this height divided can be uniform and nonuniform. For example, this height divided can be lowered and can heighten it gradually in the step of the beginning. Arid, to this inverse, it can be heightened and can lower it gradually in the step of the beginning. This can be determined by the kind of the wafer 19, the difference of a processing condition, the performance of the electrostatic adsorption, etc.

Even if it is made which, the present invention does not remove the wafer 19 electrostatic-adsorbed to the sample atage 8 at a dash from the sample atage 8. The present invention clivides the operation that pushes up the lift pin 18 into several times. Arid then, the wafer 19 electrostatic-adsorbed to the sample stage 8 weakening the electrostatic adsorption power that works to the wafer 19 by the reaction force of the wafer 19 gradually is removed from the sample stage 8. Needless to say, the height that pushes up the lift pin 18 in the step of once is a height that a deviation of a level direction and a damage do not occur in the wafer 19.

In case of the embodiment, the wafer 19 is carried in the vacuum chamber 7 with transfer equipment such as a robot hand, and it is carried out. Therefore, the wafer 19 is pushed up 10mm or 15mm from the sample mounting face of the sample stage 8, that is, the surface of sample stage 8 finally. But when it is pushed up an about 3mm, the wafer 19 is substantially released from the electrostatic adsorption power. Then, in case of the embodiment, this 3mm is divided equally 6, and dividing into 6 times, the wafer 8 is pushed up gradually by 0.5mm. That is, the lift pin 18 is pushed up 0.5mm in the step of once, and is stopped in a predetermind time. As for this stop time, it is desirable that one for 10 seconds from 3 seconds is selected. In case of this embodiment, this stop time set 5 seconds. In case only 0.5mm pushes up the lift pin 18 in the step of once, when it is pushed up, and the push up speed is fast, the wafer 19 has been damaged by an impact. In this embodiment, 0.5mm pushes up the lift pin 18 for 0.5 seconds.

Fig. 3 is the figure that showed a flow of these etching processing. As follows, Fig. 3 is explained.

In step S1, after adsorbing the sample 19, that is, the wafer 19 on the sample stage 8, etching processing is started. In step S2, an end of the etching processing is confirmed. In step S3, the electrostatic adsorption is released. In step S3, a voltage that is adverse at the time of the electrostatic adsorption of the wafer 19 is applied to sample stage 8 concretely.

Then, it is judged whether a release of the electrostatic adsorption substantially finished in step S4. It can be done concretely by detecting the torque that is added to the stepping motor 20 at this time that pushes up the lift pin 18 by a stepping motor 20. That is, it can be confirmed that if torque more than a value determined in advance to the stepping motor 20 at this time is added, a release of a electrostatic adsorption has not been completed. And, it can be confirmed that if it is more than the value that the torque of the stepping motor 20 determined in advance, a release of a electrostatic adsorption has been completed. And, the torque of this stepping motor 20 can be detected by detecting the load electric current of the stepping motor 20, the load voltage of the stepping motor, etc..

In case the wafer 19 is electrostatic-adsorbed to the sample stage 8, heat transfer gas is supplied to a delicate space between the surface of the sample stage 8 and the back of the wafer 19. In case the electrostatic adsorption power against the wafer 19 is released, the supply pressure of this heat transfer gas becomes lower than a pressure at the time of etching. By using this characteristics, a release of the electrostatic adsorption can be confirmed. In case it can be confirmed that a electrostatic adsorption is released in step 4, processing is transferred to step S5. In step S5, the lift pin 18 is pushed up at a set speed to the height that is necessary for the transfer of the wafer 19 from the surface of the sample stage 8 by the stepping motor 20. And then, processing is transferred to step S6, and in this step S6, the wafer 19 is transferred.

In case in step S4, the electrostatic adsorption is not released, processing is transferred to step S7. In step S7, only height set by a parameter pushes up the lift pin 18 at a speed set by a parameter. This is as the foregoing was done, if it says in the embodiment. That is, as for 0.5mm and highly, the speed is 0.5mm in 0.5 seconds. Then, in step S8, only time set by a parameter stops the lift pin 18. This stop time is 5 seconds that for example, the foregoing happened. It is judged whether only setting frequency repeated processing of steps S7 and S8 in step S9 after processing of step S8 ended. For example, this repeat frequency is 6 times. If the execution frequency of steps S7 and S8 does not attain the prescribed frequency, processing is returned to step S7. If the execution frequency of steps S7 and S8 attains the prescribed frequency, processing is transferred to step S10. In step S10, the wafer 19 is pushed up to the final height, and processing is transferred to step S6. This final height is the height of 15mm from 10mm above sample stage 18. And then, in step S6, the wafer 19 is transferred to the outside by using a robot hand, and a series of processing is ended.

The example that above happened explained the structure that was made push up the lift pin 18 from the surface of sample stage 8. But this can fix the lift pin 18, and it can be made structure into which the sample stage 8 drops. In case of this structure, it is composed to be able to move the sample stage 8 to a top and bottom direction in the drives such as a stepping motor 20. And, it can be composed to push up the wafer 19 as a result by an operation to which a rise of the lift pin 18 and decrease of the sample stage 8 were combined. In short, if it is structure from which the wafer 19 and the sample stage 8 relatively separate, it is possible to apply a present invention. That is, as a result, according to a present invention, from the surface of the sample stage 8, the lift pin 18 is pushed up. And, in Fig. 3, the rise speed and the height of the lift pin 18 in step S7, the stillness time in step S9 and the repeat frequency in step S8 supposed and explained that it was set in advance. But the kind of the wafer 19, the difference of a processing condition, the performance of a electrostatic adsorption, etc. change these values. Therefore, as for these values, the optional setting to the control unit is valid. On this occasion any 1 value can be fixedly set, and other values can be determined on the basis of this fixed value.

This method can be applied to the processor of an electrostatic adsorption method of using the plasma of another systems such as the RF plasma as well as a semiconductor processor using the ECR plasma using a microwave.

By as mentioned above composing, the sample can be removed from the sample stage without shifting to a level direction.Therefore, the present invention has an effect that the sample after a processing end can be transferred promptly and certainly.

## Claims

1. A sample removal method in which the sample that electrostatic-adsorbed that applied a electrostatic adsorption voltage to a sample stage arranged in the vacuum chamber is removed from the sample stage, said method comprises the steps of:
a first step for pushing up a lift pin to remove the sample from the sample stage from the sample stage relatively to a predetermined height;
a second step for making the lift pin stand still for a predetermined time after an end of the first step;
by repeating the first step and the second step, the sample is removed from the sample stage.

2. A sample removal method of claim 1 wherein said first step for pushing down a lift pin to remove the sample from the sample stage from the sample stage relatively to a predetermined height, said second step for making the sample stage stand still for a predetermined time after an end of the first step.

3. A sample removal method in which the sample that electrostatic-adsorbed that applied a electrostatic adsorption voltage to a sample stage arranged in the vacuum chamber is removed from the sample stage which comprises the steps of:
a first step for pushing up a lift pin to remove the sample from the sample stage from the sample stage relatively to a predetermined height;
a second step for making the lift pin stand still for a predetermined time after an end of the first step;
a third step for pushing down the sample stage to remove the sample from the sample stage from the lift pin relatively to a predetermined height;
a fourth step for making the sample stage stand still for a predetermined time after an end of the third step;
by iterating the first, the second, the third, and the fourth step, the sample is removed from the sample stage.

4. A sample removal apparatus in which the sample that electrostatic-adsorbed that applied a electrostatic adsorption voltage to a sample stage arranged in the vacuum chamber is removed by a lift pin from the sample stage which comprises:
a drive unit for driving the lift pin relatively apart from the sample stage;
a control unit for controlling the drive unit to repeat the control that push up the Lift pin to remove a sample from the sample stage from the sample stage relatively to a predetermined height and the control that make the lift pin stand still for a predetermined time, and to remove the sample from the sample stage.

5. A sample removal apparatus of claim 4 wherein said control unit for controlling the drive unit to repeat the control that push down the sample stage to remove the sample from the sample stage from the lift pin relatively to a predetermined height, and the control that make the sample stage stand still for a predetermined time, and to remove the sample from the sample stage.

6. A sample removal apparatus of claim 4 wherein said control unit for controlling the drive unit to repeat the control that push up the lift pin from the sample stage relatively to a predetermined height and the control that make the lift pin stand still for a predetermined time and the control that push down the sample from the lift pin relatively to a predetermined height and the control that make the sample stage stand still for a predetermined time.

7. A sample removal method in which the sample that electrostatic-adsorbed that applied a electrostatic adsorption voltage to a sample stage arranged in the vacuum chamber is removed by a lift pin from the sample stage, said method comprises the steps of:
a first step that pushes up the lift pin to a unit height that divided a height that is necessary to substantially release an influence of the electrostatic adsorption from the sample stage into multiplicity;
a second step that stops relative movement with the lift pin and the sample stage between a predetermined time after an end of the first step;
by repeating the first step and the second step, the sample pushes up from the sample stage to the height that is necessary to substantially release an influence of the electrostatic adsorption from the sample stage.

8. A sample removal apparatus in which the sample that electrostatic-adsorbed that applied a electrostatic adsorption voltage to a sample stage arranged in the vacuum chamber is removed by a lift pin from the sample stage which comprises:
a drive unit for driving the lift pin relatively apart from the sample stage;
a control unit for controlling the drive unit to repeat the control that pushes up the lift pin to a unit height that divided a height that is necessary to substantially release an influence of the electrostatic adsorption from the sample stage into multiplicity and the control that stops relative movement with the lift pin and the sample stage between a predetermined time, and to push up the sample from the sample stage to the height that is necessary to substantially release an influence of the electrostatic adsorption from the sample stage.
